# EUROPEAN PATENT SPECIFICATION

(11) **EP 1 378 932 B1**
(45) Date of publication and mention of the grant of the patent: **04.04.2007**
(21) Application number: 03014236.8
(22) Date of filing: 25.06.2003
(51) Int. Cl.: H01L 21/00

(54) **Semiconductor chip mounting apparatus and mounting method**
Apparat zur Befestigung von Halbleiterchips und eine Methode zur Befestigung
Dispositif et procédé de montage d'une puce semi-conducteur

(30) Priority: 01.07.2002 JP 2002192170
(43) Date of publication of application: 07.01.2004
(73) Proprietor: SHINKO ELECTRIC INDUSTRIES CO. LTD., Nagano-shi, Nagano 380-0921 (JP)
(72) Inventor: Murayama, Kei, Oaza Kurita, Nagano-shi, Nagano 380-0921 (JP)
(74) Representative: Patentanwälte Ruff, Wilhelm, Beier, Dauster & Partner

(56) References cited:
- US-A- 4 911 543
- PATENT ABSTRACTS OF JAPAN vol. 0111, no. 10 (E-496), 7 April 1987 (1987-04-07) & JP 61 259539 A (NEC CORP), 17 November 1986 (1986-11-17)

## Description

### BACKGROUND OF THE INVENTION

### 1. Field of the Invention

The present invention relates to semiconductor chip mounting apparatus and mounting method for mounting a semiconductor chip on a semiconductor package or other substrate by flip-chip bonding.

### 2. Description of the Related Art

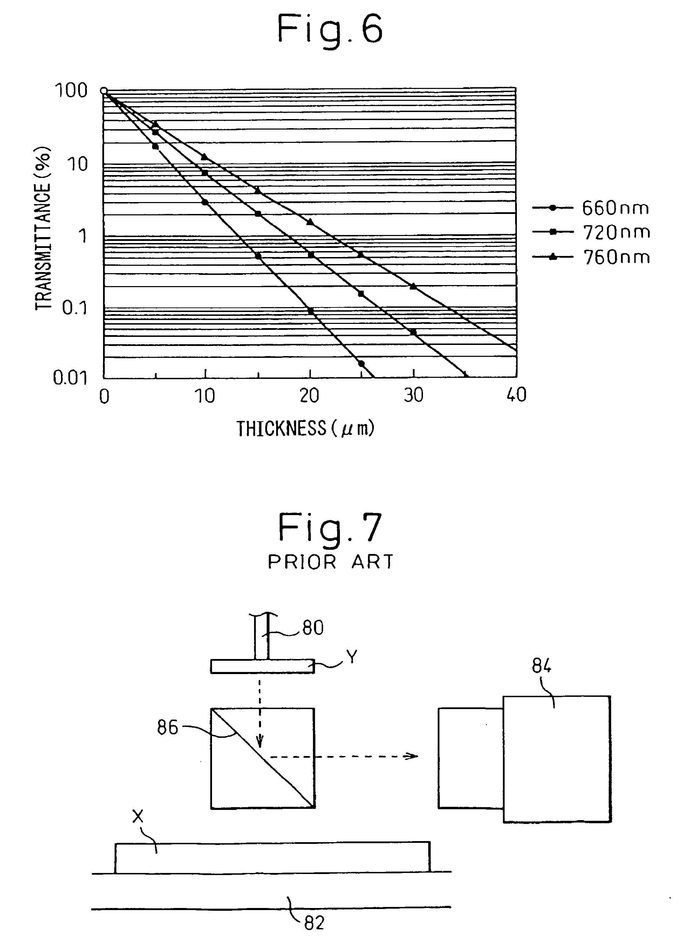

A conventional method of mounting a semiconductor chip on a semiconductor package or other substrate by flip-chip bonding will be explained using FIGS. 7 to 9. FIGS. 7 to 9 are views explaining the conventional method for mounting a semiconductor chip Y comprised of silicon on a package X serving as a substrate.

In the conventional method of mounting a semiconductor chip, as shown in FIG. 7, a holder 80 clamps and holds a semiconductor chip Y and conveys it above the package X serving as the substrate carried on a stage 82. Next, a mirror 86 is inserted between the semiconductor chip Y and package X and arranged so that the surface of the mirror 86 forms an angle of 45 degrees with the surface of the semiconductor chip Y so as to capture the patterns formed on the bonding surface of the semiconductor chip Y at a camera 84 provided horizontally at the side of the stage 82. A not shown controller to which the camera 84 is connected stores the image of the protected patterns.

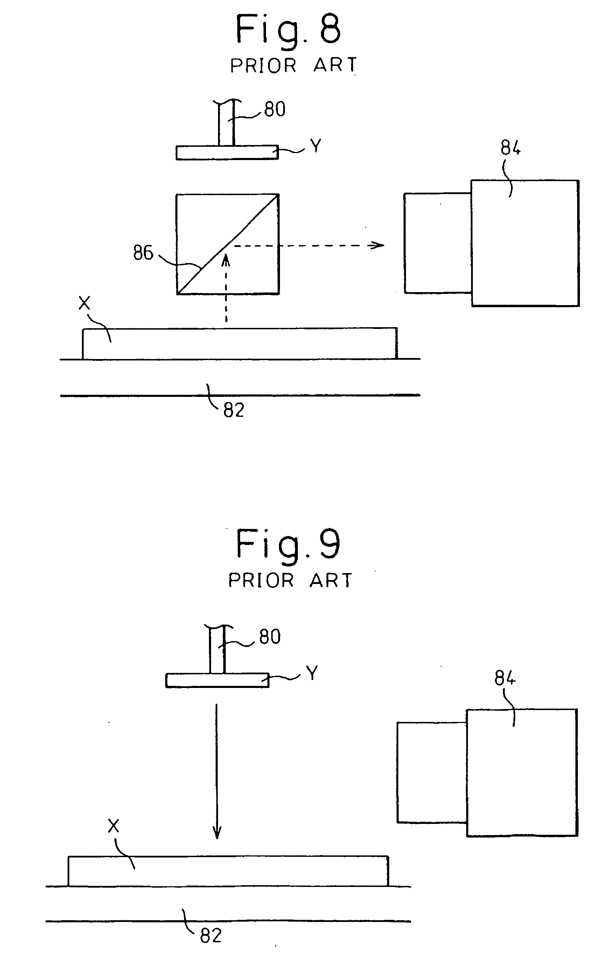

Next, as shown in FIG. 8, the mirror 86 is rotated clockwise 90 degrees in the figure to capture the patterns formed on the semiconductor chip mounting area on the top surface of the package X at the camera 84. The controller compares the image of the patterns of the semiconductor chip Y stored and the image of the patterns of the package X captured and based on this controls a not shown drive unit to move the stage 82 in the horizontal direction and thereby match with the mounting position of the semiconductor chip Y on the package X.

Next, as shown in FIG. 9, the mirror 86 is taken away, the semiconductor chip Y is lowered, released from clamping by the holder 80, and placed on the semiconductor chip mounting area of the package X, and a not shown heating means is used to heat the semiconductor chip Y so as to cause the bumps formed on the bonding surface of the semiconductor chip Y to reflow and bond the semiconductor chip to the package X.

Summarizing the problems to be solved by the invention, with the conventional method of mounting a semiconductor chip, it is difficult to maintain the accuracy of the angle of the mirror arranged between the semiconductor chip Y and package X. A slight deviation in angle of the mirror 86 easily results in the mounting position of the semiconductor chip Y on the package X deviating.

Further, after arranging and positioning the mirror 86 between the semiconductor chip Y and the package X, the semiconductor chip Y is moved above the package X, so after positioning, the distance of movement of the semiconductor chip Y is large. Therefore, there is the problem that the mounting position of the semiconductor chip Y on the package X ends up deviating according to the accuracy of the unit for moving the semiconductor chip Y.

[0007a] An other conventional method of detecting a semiconductor pellet is shown in the Japanese patent abstract JP 61 259 539 A, wherein an attracting nozzle for conveying said pellets provides an optical fiber within. Light emitted by a light source is transmitted through said optical fibre and passes through the nozzle in a pellet attracting area of the nozzle. A detecting machine comprising a photoreceptor detects the emitted light if no semiconductor pellet is attracted to the pellet attracting nozzle, e.g. when the light emitting area is not covered. Further, light is emitted and detected when the semiconductor pellet is warped by means of a high suction or when a semiconductor pellet is not attracted correctly to the nozzle, e.g. because the semiconductor pellet is attracted displaced to the nozzle. If a semiconductor pellet is correctly attracted, no light is emitted and detected.

### SUMMARY OF THE INVENTION

An object of the present invention is to provide a semiconductor chip mounting apparatus and mounting method with a good positional accuracy when mounting a semiconductor chip on a package. Another object is to provide a semiconductor chip mounting apparatus and mounting method with a good efficiency and low cost.

To attain the above object, according to a first aspect of the present invention, there is provided a semiconductor chip mounting apparatus for mounting a semiconductor chip on a substrate by flip-chip bonding comprising a stage on which the substrate is carried, a visible light source for directly illuminating the substrate from above the stage, a semiconductor chip conveying means for holding from one surface the semiconductor chip comprised of silicon formed to a thickness through which visible light can pass and conveying it on the substrate carried on the stage, a capturing means arranged at a position facing the stage and capturing visible light passing through the semiconductor chip held by the semiconductor chip conveying means so as to capture patterns formed on the substrate carried on the stage and the semiconductor chip, and a positioning means for positioning the semiconductor chip on the substrate based on the patterns of the substrate and the semiconductor chip captured by the capturing means.

Preferably the thickness of the semiconductor chip is 5 to 20 µm.

According to this, since the visible light passing through the semiconductor chip is captured so as to capture the patterns of the substrate and the patterns of the semiconductor chip, it is possible to position the substrate and the semiconductor chip and position them accurately in a state with the two patterns brought into close proximity and superposed.

Preferably, the visible light includes light of a wavelength of 660 to 760 nm. According to this, it is possible for the visible light to more easily pass through the semiconductor chip and for a sufficient positional accuracy to be obtained. Lights of a wavelength of less than 660 nm are easily absorbed by the semiconductor chip and are difficult to pass therethrough. On the other hand, lights of a wavelength of more than 760 nm cannot ensure sufficient positional accuracy.

Preferably, the semiconductor chip conveying means clamps and holds the semiconductor chip at a plurality of locations. According to this, the force for holding the semiconductor chip is dispersed among a plurality of locations and the semiconductor chip held by the semiconductor chip conveying means will not warp in shape.

Preferably, the semiconductor chip conveying means has a transparent part through which visible light passes up to the held semiconductor chip. According to this, it is possible to capture visible light passing through the semiconductor chip by a capturing means without being blocked by the semiconductor chip conveying means.

According to a second aspect of the present invention, there is provided a semiconductor chip mounting method for mounting a semiconductor chip on a substrate by flip-chip bonding including the steps of holding a semiconductor chip comprised of silicon formed to a thickness passing visible light by a semiconductor chip conveying means from one surface and conveying it on a substrate carried on a stage, directly illuminating the substrate with visible light from above the stage, capturing visible light passing through the semiconductor chip by a capturing means arranged at a position facing the stage and thereby capturing patterns formed by the substrate and the semiconductor chip and positioning the semiconductor chip on the substrate based on the patterns, and attaching the semiconductor chip to the mounting position on the substrate.

Preferably, the thickness of the semiconductor chip is 5 to 20 µm. According to this, since the visible light passing through the semiconductor chip is captured so as to capture the patterns of the substrate and the patterns of the semiconductor chip, it is possible to position the substrate and the semiconductor chip and position them accurately in a state with the two patterns brought into close proximity and superposed.

Preferably, the visible light includes light of a wavelength of 660 to 760 nm. According to this, it is possible for the visible light to more easily pass through the semiconductor chip and for a sufficient positional accuracy to be obtained.

Preferably, the semiconductor chip conveying means clamps and holds the semiconductor chip at a plurality of locations. According to this, the force for holding the semiconductor chip is dispersed among a plurality of locations and the semiconductor chip held by the semiconductor chip conveying means will not warp in shape.

Preferably, the semiconductor chip conveying means has a transparent part through which visible light passes up to the held semiconductor chip and the positioning step passes visible light passing through the semiconductor chip through the transparent part and captures it by the capturing means. According to this, it is possible to capture visible light passing through the semiconductor chip by a capturing means without being blocked by the semiconductor chip conveying means.

### BRIEF DESCRIPTION OF THE DRAWINGS

These and other objects and features of the present invention will become clearer from the following description of the preferred embodiments given with reference to the attached drawings, wherein:
FIG. 1 is a view of a semiconductor chip mounting apparatus according to the present invention;
FIG. 2 is a plan view of a holding surface of a holder of a semiconductor chip conveying means;
FIG. 3 is a side sectional view of a holder of a semiconductor chip conveying means;
FIG. 4 is a side sectional view of a holder of a semiconductor chip conveying means,
FIG. 5 is a plan view of a bonding surface of a semiconductor chip to a substrate (package);
FIG. 6 is a graph of the relationship between a thickness of silicon and a transmittance rate of visible light;
FIG. 7 is a view of a conventional semiconductor chip mounting apparatus and mounting method;
FIG. 8 is a view of a conventional semiconductor chip mounting apparatus and mounting method; and
FIG. 9 is a view of a conventional semiconductor chip mounting apparatus and mounting method.

### DESCRIPTION OF THE PREFERRED EMBODIMENTS

Preferred embodiments of the present invention will be described in detail below while referring to the attached figures.

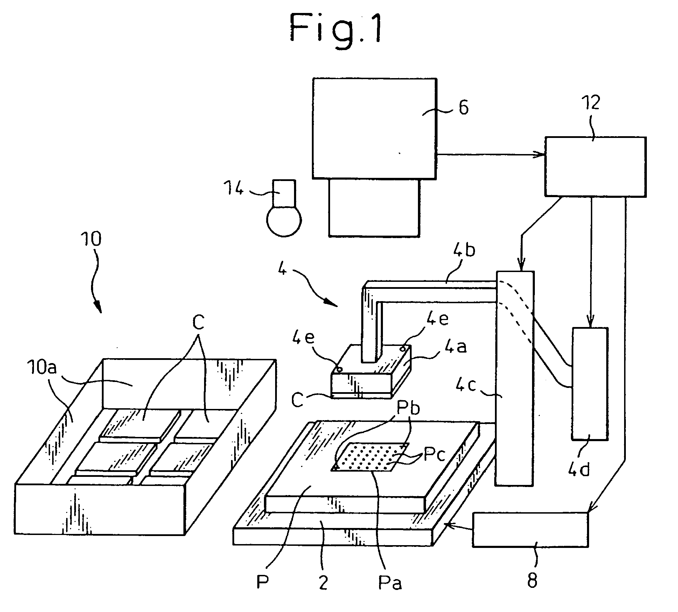

FIG. 1 is a view explaining the configuration of a semiconductor chip mounting apparatus according to a first embodiment. The semiconductor chip mounting apparatus according to this embodiment is for mounting a semiconductor chip C made of silicon on a package P serving as a substrate by flip-chip bonding. The semiconductor chip mounting apparatus according to the present invention, as shown in FIG. 1, is provided with a stage 2 for holding a package P, a visible light source 14 for directly illuminating the package (substrate) P from above the stage 2, a semiconductor chip conveying means 4 for holding from one surface the semiconductor chip C formed to a thickness passing visible light and conveying it above the package P held on the stage 2, a camera 6 serving as a capturing means arranged at a position facing the stage 2, and a controller 12 provided with a CPU.

The stage 2 is formed on its top surface with a carrying surface for carrying the package P. Not shown pins etc. are used to attach the package P on the carrying surface and hold the package P. The stage 2 is provided to be able to freely move in the plane formed by the carrying surface by a drive unit 8 controlled by the controller 12.

The semiconductor chip conveying means 4 is comprised of a holder 4a for clamping and holding a semiconductor chip C formed to a thickness passing visible light, an arm 4b extending from the holder 4a and formed inside it with a cavity through which air for clamping the semiconductor chip C passes, a drive unit 4c for moving the semiconductor chip C held by the holder 4a through the arm 4b, and a clamping device 4d for sucking the air in the arm 4b. The drive unit 4c and clamping device 4d are controlled by the controller 12.

The holder 4a is moved via the arm 4b by the drive unit 4c. The holder 4a is provided movably, by the drive unit 4c, over the semiconductor chip mounting area Pa of the package P carried on the stage 2 from inside the tray 10 where the semiconductor chips C before placement on the stage 2 are carried. Note that the outer circumference of the tray 10 is formed with a wall 10a for shielding so that the semiconductor chips C carried are not blown off.

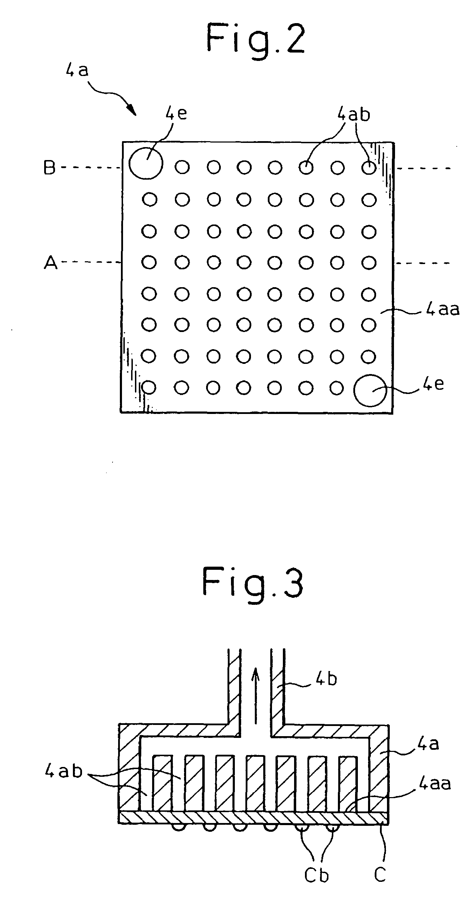

A view of the surface 4aa (bottom surface) of the holder 4a for holding the semiconductor chips C is shown in FIG. 2. The holding surface 4aa of the holder 4a is formed with a plurality of holes 4ab over substantially its entire surface. As shown in FIG. 3 (side sectional view along line A of holder 4a), the holes 4ab communicate with the cavity in the arm 4b. Therefore, by the clamping device 4d drawing out the air inside the arm 4b, the air is sucked in from the holes 4ab. It is possible to clamp one surface of the semiconductor chip C at a plurality of locations over the entire surface and hold the semiconductor chip C by making it stick to the holding surface 4aa. Note that the holder 4a is not limited to this type. For example, by forming it from porous body such as a porous ceramic substrate and sucking the air from the top surface of the porous body to make the pores negative in pressure, it is possible to make the semiconductor chip C stick to and be held at the bottom surface of the porous body.

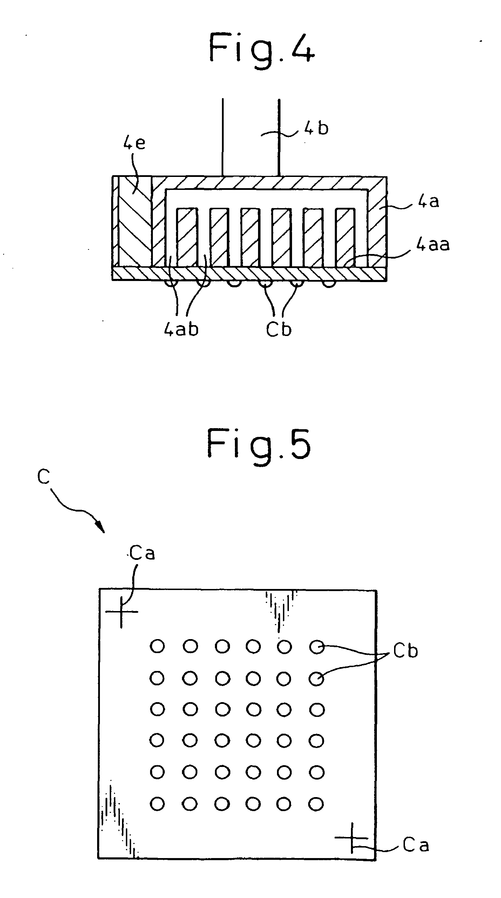

Further, as shown in FIG. 2 and FIG. 4, the holder 4a of the semiconductor chip conveying means 4 is provided with a plurality of transparent parts 4e made of glass etc. passing visible light up to the held semiconductor chip C. The transparent parts 4e are for allowing visible light passing through the semiconductor chip C held at the holder 4a to reach the camera 6.

FIG. 5 is an explanatory plan view seen from the bonding surface with a package P of a semiconductor chip C attached to a package P by a semiconductor chip mounting apparatus of the present invention. The bonding surface of the semiconductor chip C is formed with bumps Cb made of solder etc. for attaching to the semiconductor chip C to the semiconductor chip mounting area Pa of the package P. Further, the bonding surface is formed with cross-shaped marking patterns Ca serving as patterns used for positioning of the mounting position of the semiconductor chip C on the package P. The marking patterns Ca are arranged to be positioned on the transparent parts 4e when the semiconductor chip C is held by the holder 4a. On the other hand, the semiconductor chip mounting area Pa of the package P, as shown in FIG. 1, is formed with pads Pc to which the bumps Cb of the semiconductor chip C are connected. Further, it is formed with cross-shaped marking patterns Pb serving as patterns for positioning of the mounting position of the semiconductor chip matching with the marking patterns Ca of the semiconductor chip C.

Note that the marking pattern Ca may also be formed not on the bonding surface, but the opposite surface where the interconnect patterns of the semiconductor chip C are formed. Further, the marking patterns Ca and Pb are not limited to cross shapes and may be any shapes able to be used for positioning. Further, the marking patterns Ca and Pb may be formed by printing or parts of the interconnect patterns formed on the semiconductor chip C and package P may be formed into cross shapes and used as the marking patterns Ca and Pb. Further, the interconnect patterns, bumps Cb, and pads Pb formed on the semiconductor chip C and package P may also be used as patterns for positioning.

Next, the series of operations when the semiconductor chip mounting apparatus according to the present embodiment mounts a semiconductor chip C on a package P will be explained using FIG. 1. First, in preparation for the work, a worker stores a plurality of semiconductor chips C for mounting on packages P in a tray 10. Next, the flow of the mounting operation will be explained. First, the worker places a package P on the carrying surface of the stage 2 so that its semiconductor chip mounting area Pa is exposed at the top surface and attaches it to the stage 2 by not shown pins etc. Next, the worker operates the input means of the controller 12 to select attachment of a semiconductor chip C. Note that the work up to here may be automated by the mounting apparatus.

### (Conveyance Step)

The controller 12 controls the drive unit 4c to make the holder 4a move to above a semiconductor chip C in the tray 10. Next, the controller 12 controls the clamping device 4d to clamp the semiconductor chip C and hold it at the holding surface 4aa. Next, the controller 12 controls the drive unit 4c to move the semiconductor chip C above the semiconductor chip mounting area Pa of the package P and then lower it to bring it close to the semiconductor chip mounting area Pa.

### (Positioning Means and Positioning Step)

At this time, the semiconductor chip C is formed to a thickness passing visible light, so the camera 6 captures the marking patterns Pb and Ca through the semiconductor chip C and the transparent part 4e. Next, the controller 12 analyzes the images of the cross-shaped marking patterns Pb and Ca captured by the camera 6 and analyzes the relative positional relationship between the package P and semiconductor chip C. The controller 12 drives the drive unit 8 or drive unit 4c based on this positional relationship so as to drive the package P or semiconductor chip C and position the semiconductor chip C on the package P.

After the positioning ends, the controller 12 lowers the semiconductor chip C slightly by the drive unit 4c to bring it into contact with the semiconductor chip mounting area Pa, then stops the operation of the clamping device 4d to place it on the semiconductor chip mounting area Pa. Next, the controller 12 moves the holder 4a away from the package P.

### (Semiconductor Chip Attachment Means and Attachment Step)

Next, a heating means, for example, bonder, used as the not shown semiconductor chip attachment means is used to heat the semiconductor chip C to melt the bumps C (solder reflow), bond the bumps Cb and pads Pc, and thereby attach the semiconductor chip C to the package P. Note that it is also possible to incorporate a heater as a heating means in the holder 4a so as to form the holder 4a and the heating means (bonder) integrally, place the semiconductor chip C on the semiconductor chip mounting area Pa, then cause the heating means to heat up to melt the bumps Cb without moving the holder 4a away from the semiconductor chip C and to attach the semiconductor chip C to the package P. Further, the semiconductor chip attachment means is not limited to the above bonder. It is also possible to employ a means of passing the package P through a heating furnace.

According to the semiconductor chip mounting apparatus and mounting method of the present embodiment, the visible light passing through the semiconductor chip C is captured so as to simultaneously capture by the camera 6 the marking patterns Pb of the semiconductor chip mounting area Pa of the package P and the marking patterns Ca of the semiconductor chip C by bringing the semiconductor chip mounting area Pa and the semiconductor chip into proximity, then the marking patterns Pb and marking patterns Ca are directly superposed for positioning. Therefore, it is possible to accurately position the chip without relying on the accuracy of the angle of the mirror 86 as in the conventional mounting method. Further, since the distance of movement of the semiconductor chip C after positioning becomes extremely short, it is possible to keep the positional deviation due to the mechanical accuracy low.

Further, since there is no step of inserting the mirror 86 between the semiconductor chip C and the package P, changing its angle, and taking it out, it is possible to quickly mount a semiconductor chip and obtain a good mounting efficiency. Further, since the mirror 86 is not necessary, the semiconductor chip mounting apparatus can be obtained at a lower cost.

Further, the holder 4a of the semiconductor chip conveying means 4a clamps the semiconductor chip C at a plurality of locations of the holes 4ab, 4ab,... arranged over substantially the entire surface of the holding surface 4aa so as to hold the holding surface 4aa. If clamping and lifting up a semiconductor chip C formed to an extremely small thickness passing visible light at a single location by a conventional holder 80 shown in FIG. 7, the semiconductor chip C will warp making accurate positioning impossible or resulting in the semiconductor chip C ending up being damaged. On the other hand, according to the semiconductor chip conveying means 4 of the present invention, the semiconductor chip C is clamped and held at a plurality of locations, so the holding force is dispersed to a plurality of locations and it is possible to hold the semiconductor chip C at the holding surface 4aa without almost any warping of its shape.

However, if the semiconductor chip C is held at a plurality of locations across the substantially entire surface of the semiconductor chip C by the semiconductor chip conveying means 4, the visible light passing through the semiconductor chip C will be blocked by the semiconductor chip conveying means 4 (holder 4a) and the new problem will arise of it not being able to be captured by the camera 6. In the semiconductor chip mounting apparatus according to the present embodiment, however, by providing the semiconductor chip conveying means 4 (holder 4a) with a transparent part 4e for passing visible light up to the semiconductor chip C held, the visible light passing through the semiconductor chip C can be captured by the camera 6 and this problem can be solved. Note that there is no need to hold substantially the entire surface of one side of the semiconductor chip C. The transparent part also need not be provided when it is possible to have part of one surface exposed from the semiconductor chip conveying means (holder) for holding.

Next, the relationship between the thickness of the semiconductor chip C made of silicon and the transmittance rate of visible light will be explained using FIG. 6. FIG. 6 is a graph of the relationship between the thickness of the silicon and the transmittance rate of visible light of a wavelength of 660 nm, 720 nm, and 760 nm. In the semiconductor chip mounting apparatus and mounting method according to the present embodiment, the wavelength and the thickness of the semiconductor chip C are preferably set so as to give a transmittance rate of about 0.1%. Further, as the upper limit of the wavelength of the visible light, it is possible to use visible light of about 830 nm or ultraviolet light. It is also possible to raise the transmittance rate the longer the wavelength. The longer the wavelength, however, the lower the resolution and the lower the positioning accuracy, so to maintain the positioning accuracy, it is preferable to use visible light of a wavelength of not more than 760 nm, more preferably about 660 nm. Further, to secure a transmittance rate of at least 0.1% at a wavelength of 660 nm, the thickness of the semiconductor chip C is preferably made not more than 20 m.

Note that to facilitate the marking patterns Pa and Ca being captured by the camera 6, as shown in FIG. 1, it is preferable to provide a light emitter 14 so as to emit visible light to Illuminate the marking patterns Pb and Ca. The light emitter 14 is for example provided adjoining the camera 6, provided around the lens of the camera 6, or otherwise provided at a position for illuminating the marketing patterns Pb and Ca.

Further, in this embodiment, the semiconductor chip C was formed with the bumps Cb, while the package P (substrate) was formed with the pads Pc, but it is also possible to form the pads at the semiconductor chip C side and the bumps at the package P (substrate) side and reflow the bumps of the package P to attach the semiconductor chip C to the package.

According to the semiconductor chip mounting apparatus and mounting method of the present invention, there are the effects that the positional accuracy when mounting the semiconductor chip on the package is good, the mounting efficiency is good, and the cost is low.

While the invention has been described with reference to specific embodiments chosen for purpose of illustration, it should be apparent that numerous modifications could be made to the embodiments by those skilled in the art without departing from the basic concept and scope of the invention.

## Claims

1. A semiconductor chip mounting apparatus for mounting a semiconductor chip on a substrate by flip-chip bonding comprising:
a stage (2) on which the substrate (P) is carried,
a visible light source (14) for directly illuminating the substrate (P) from above the stage (2),
a semiconductor chip conveying means (4) for holding from one surface said semiconductor chip (C) comprised of silicon formed to a thickness through which visible light can pass and conveying it on said substrate (P) carried on the stage (2),
a capturing means (6) arranged at a position facing said stage (2) and capturing visible light passing through said semiconductor chip (C) held by said semiconductor chip conveying means (4) so as to capture patterns (Ca, Pb) formed on the substrate (P) carried on said stage (2) and said semiconductor chip (C), and
a positioning means (4) for positioning said semiconductor chip (C) on said substrate (P) based on the patterns (Ca, Pb) of said substrate (P) and said semiconductor chip (C) captured by said capturing means (6) .

2. A semiconductor chip mounting apparatus as set forth in claim 1, wherein said semiconductor chip conveying means (4) is adapted to pass light through said semiconductor chips (C) with a thickness of 5 to 20 µm.

3. A semiconductor chip mounting apparatus as set forth in claim 1 or 2, wherein said visible light includes light of a wavelength of 660 to 760 nm.

4. A semiconductor chip mounting apparatus as set forth in any of the preceding claims, wherein said semiconductor chip conveying means (4) clamps and holds said semiconductor chip (C)at a plurality of locations (4ab).

5. A semiconductor chip mounting apparatus as set forth in any of the preceding claims, wherein said semiconductor chip conveying means (4) is provided with at least one transparent part (4e) and clamps and holds said semiconductor chip (C) at its entire surface (4aa) other than said transparent parts (4e).

6. A semiconductor chip mounting apparatus as set forth in any of claims 1 to 4, wherein said semiconductor chip conveying means (4) has a transparent part (4e) through which visible light passes up to the held semiconductor chip (C).

7. A semiconductor chip mounting method for mounting a semiconductor chip on a substrate by flip-chip bonding including the steps of:
holding a semiconductor chip (C) comprised of silicon formed to a thickness passing visible light by a semiconductor chip conveying means (4) from one surface and conveying it on a substrate (P) carried on a stage (2),
directly illuminating said substrate (P) with visible light from above the stage (2),
capturing visible light passing through said semiconductor chip (C) by a capturing means (6) arranged at a position facing said stage (2) and thereby capturing patterns (Ca, Pb) formed by said substrate (P) and said semiconductor chip (C) and positioning said semiconductor chip (C) on said substrate (P) based on said patterns (Ca, Pb), and
attaching said semiconductor chip (C) to said mounting position on said substrate (P).

8. A semiconductor chip mounting method as set forth in claim 7, wherein said semiconductor chip conveying means (4) is adapted to pass light through said semiconductor chips (C) with a thickness of 5 to 20 µm.

9. A semiconductor chip mounting method as set forth in claim 7 or 8, wherein said visible light includes light of a wavelength of 660 to 760 nm.

10. A semiconductor chip mounting method as set forth in any of claims 7 to 9, wherein said semiconductor chip conveying means (4) clamps and holds said semiconductor chip (C) at a plurality of locations (4ab).

11. A semiconductor chip mounting method as set forth in claim 10, wherein said semiconductor chip conveying means (4) is provided with at least one transparent part (4e) and clamps and holds said semiconductor chip (C) at its entire surface other than said transparent parts (4e).

12. A semiconductor chip mounting method as set forth in any of claims 7 to 11, wherein:
said semiconductor chip conveying means (4) has a transparent part (4e) through which visible light passes up to the held semiconductor chip (C) and
said positioning step passes visible light passing through said semiconductor chip (C) through said transparent parts (4e) and captures it by said capturing means (6).

## Patentansprüche

1. Apparat zur Befestigung von Halbleiterchips zur Befestigung eines Halbleiterchips auf einem Substrat durch Flip-Chip-Lötstellentechnik, bestehend aus:
- einer Unterlage (2), die das Substrat (P) trägt,
- einer Quelle sichtbaren Lichts (14) zur direkten Beleuchtung des Substrats (P) von oberhalb der Unterlage (2),
- einem Transportmittel (4) für den Chip, das den Halbleiterchip (C) an einer Oberfläche hält und zu dem Substrat (P) auf der Unterlage (2) transportiert, wobei der aus Silizium bestehende Chip eine Dicke aufweist, so dass Licht hindurch scheinen kann,
- einem Erfassungsmittel (6), das in einer Stellung gegenüber der Unterlage (2) angeordnet ist und das das durch den vom Transportmittel (4) für den Chip gehaltenen Chip (C) hindurchgehende Licht auffängt, um Muster (Ca, Pb) zu erfassen, welche sich auf dem auf der Unterlage (2) liegenden Substrat (P) und auf dem Halbleiterchip (C) bilden, sowie
- einem Positionierungsmittel (4), das den Halbleiterchip (C) auf dem Substrat (P) auf der Grundlage der vom Erfassungsmittel (6) auf dem Substrat (P) und dem Halbleiterchip (C) erfassten Muster (Ca, Pb) positioniert.

2. Apparat zur Befestigung von Halbleiterchips gemäß Anspruch 1, wobei das Transportmittel (4) für den Chip so ausgelegt ist, dass es Licht durch die 5 µm bis 20 µm starken Halbleiterchips hindurchgehen lässt.

3. Apparat zur Befestigung von Halbleiterchips gemäß Anspruch 1 oder 2, wobei das sichtbare Licht Licht einer Wellenlänge von 660 nm bis 760 nm umfasst.

4. Apparat zur Befestigung von Halbleiterchips gemäß einem beliebigen der vorstehenden Ansprüche, wobei das Transportmittel (4) für den Halbleiterchip den Halbleiterchip (C) an einer Vielzahl von Stellen (4ab) klammert und festhält.

5. Apparat zur Befestigung von Halbleiterchips gemäß einem beliebigen der vorstehenden Ansprüche, wobei das Transportmittel (4) für den Halbleiterchip zumindest mit einem durchsichtigen Teil (4e) versehen ist und den Halbleiterchip (C) auf seiner gesamten Oberfläche (4aa) mit Ausnahme der durchsichtigen Teile (4e) klammert und festhält.

6. Apparat zur Befestigung von Halbleiterchips gemäß einem beliebigen der Ansprüche 1 bis 4, wobei das Transportmittel (4) für den Halbleiterchip mit einem durchsichtigen Teil (4e) versehen ist, das sichtbares Licht bis zum festgehaltenen Halbleiterchip (C) passieren lässt.

7. Verfahren zum Befestigen eines Halbleiterchips auf einem Substrat durch Flip-Chip-Lötstellentechnik, das die folgenden Schritte aufweist:
- Festhalten auf einer Seite eines aus Silizium bestehenden Halbleiterchips (C), der eine Dicke aufweist, so dass Licht hindurch scheinen kann, durch ein Transportmittel (4) für Halbleiterchips und Transportieren dieses Chips zu einem Substrat (P), das auf einer Unterlage (2) liegt,
- direktes Beleuchten des Substrats (P) von oberhalb der Unterlage (2) durch sichtbares Licht,
- Erfassen des durch den Halbleiterchip (C) hindurchgehenden Lichts mittels eines Erfassungsmittels (6), das in einer Stellung gegenüber der Unterlage (2) angeordnet ist und **dadurch** Muster (Ca, Pb) erfasst, welche sich auf dem Substrat (P) und dem Halbleiterchip (C) bilden, sowie Positionieren des Halbleiterchips (C) auf dem Substrat (P) auf der Grundlage der Muster (Ca, Pb), und
- Verbinden des Halbleiterchips (C) in dieser Befestigungsposition mit dem Substrat (P).

8. Verfahren zum Befestigen von Halbleiterchips gemäß Anspruch 7, wobei das Transportmittel (4) für den Chip so ausgelegt ist, dass es Licht durch die 5 µm bis 20 µm starken Halbleiterchips (C) hindurchgehen lässt.

9. Verfahren zum Befestigen von Halbleiterchips gemäß Anspruch 7 oder 8, wobei das sichtbare Licht Licht einer Wellenlänge von 660 nm bis 760 nm umfasst.

10. Verfahren zum Befestigen von Halbleiterchips gemäß einem beliebigen der Ansprüche 7 bis 9, wobei das Transportmittel (4) für den Halbleiterchip den Halbleiterchip (C) an einer Vielzahl von Stellen (4ab) klammert und festhält.

11. Verfahren zum Befestigen von Halbleiterchips gemäß Anspruch 10, wobei das Transportmittel (4) für den Halbleiterchip zumindest mit einem durchsichtigen Teil (4e) versehen ist und den Halbleiterchip (C) auf seiner gesamten Oberfläche auf der anderen Seite des durchsichtigen Teils (4e) klammert und festhält.

12. Verfahren zum Befestigen von Halbleiterchips gemäß einem beliebigen der Ansprüche 7 bis 11, wobei:
- das Transportmittel (4) für den Halbleiterchip mit einem durchsichtigen Teil (4e) versehen ist, das sichtbares Licht bis zum festgehaltenen Halbleiterchip (C) passieren lässt, und wobei
- beim Schritt des Positionierens sichtbares Licht durch den Halbleiterchip (C) und durch das durchsichtige Teil (4e) hindurch scheint und mit dem Erfassungsmittel (6) aufgefangen wird.

## Revendications

1. Dispositif de montage d'une puce semi-conducteur afin de monter une puce semi-conducteur sur un substrat par la technologie de la "puce retournée" (flip-chip), comprenant :
- un support (2) sur lequel le substrat (P) est posé,
- une source de lumière visible (14) qui éclaire directement le substrat (P) par le dessus du substrat (P),
- un moyen de transport (4) de la puce semi-conducteur pour maintenir par une surface ladite puce semi-conducteur (C) composée de silicium et formée à une épaisseur laissant passer la lumière visible, et pour la transporter sur ledit substrat (P) posé sur le support (2),
- un moyen de saisie (6), disposé à une position en face dudit support (2), et qui reçoit la lumière visible passant à travers ladite puce semi-conducteur (C) maintenue par ledit moyen de transport (4) de la puce semi-conducteur afin de saisir les motifs (Ca, Pb) se formant sur le substrat (P) portée par le support (2) et sur ladite puce semi-conducteur (C), et
- un moyen de positionnement (4) pour positionner ladite puce semi-conducteur (C) sur ledit substrat (P) en fonction des motifs (Ca, Pb) se formant sur ledit substrat (P) et ladite puce semi-conducteur (C) et saisis par ledit moyen de saisie (6).

2. Dispositif de montage d'une puce semi-conducteur selon la revendication 1, dans lequel ledit moyen de transport (4) de la puce semi-conducteur est conçu pour laisser passer la lumière à travers ladite puce semi-conducteur (C) d'une épaisseur de 5 µm à 20 µm.

3. Dispositif de montage d'une puce semi-conducteur selon la revendication 1 ou 2, dans lequel ladite lumière visible comprend de la lumière d'une longueur d'onde de 660 nm à 760 nm.

4. Dispositif de montage d'une puce semi-conducteur selon une quelconque des revendications précédentes, dans lequel ledit moyen de transport (4) de la puce semi-conducteur accroche et maintient ladite puce semi-conducteur (C) à une multitude d'endroits (4ab).

5. Dispositif de montage d'une puce semi-conducteur selon une quelconque des revendications précédentes, dans lequel ledit moyen de transport (4) de la puce semi-conducteur est équipé d'au moins une partie transparente (4e) et accroche et maintient ladite puce semi-conducteur (C) par sa surface entière (4aa) à l'exception de ladite partie transparente (4e).

6. Dispositif de montage d'une puce semi-conducteur selon une quelconque des revendications 1 à 4, dans lequel ledit moyen de transport (4) de la puce semi-conducteur possède une partie transparente (4e) qui laisse passer la lumière visible jusqu'à la puce semi-conducteur (C) maintenue.

7. Méthode de montage d'une puce semi-conducteur afin de monter une puce semi-conducteur sur un substrat par la technologie de la "puce retournée" (flip-chip), comprenant les étapes suivantes :
- maintien par une face d'une puce semi-conducteur (C), composée de silicium et formée à une épaisseur laissant passer la lumière, à l'aide d'un moyen de transport (4) de la puce semi-conducteur et transport de celle-ci vers un substrat (P) posé sur un support (2),
- éclairage direct dudit substrat (P) par le dessus du support (2) au moyen de lumière visible,
- saisie de la lumière visible passant à travers ladite puce semi-conducteur (C) par un moyen de saisie (6) disposé à une position en face dudit support (2) afin de saisir les motifs (Ca, Pb) se formant sur ledit substrat (P) et ladite puce semi-conducteur (C), et positionnement de ladite puce semi-conducteur (C) sur le substrat (P) en fonction desdits motifs (Ca, Pb), et
- fixation de ladite puce semi-conducteur (C) en cette position de montage sur ledit substrat (P).

8. Méthode de montage d'une puce semi-conducteur selon la revendication 7, dans laquelle ledit moyen de transport (4) de la puce semi-conducteur est conçu pour laisser passer la lumière à travers ladite puce semi-conducteur (C) d'une épaisseur de 5 µm à 20 µm.

9. Méthode de montage d'une puce semi-conducteur selon la revendication 7 ou 8, dans laquelle ladite lumière visible comprend de la lumière d'une longueur d'onde de 660 nm à 760 nm.

10. Méthode de montage d'une puce semi-conducteur selon une quelconque des revendications 7 à 9, dans laquelle ledit moyen de transport (4) de la puce semi-conducteur accroche et maintient ladite puce semi-conducteur (C) à une multitude d'endroits (4ab).

11. Méthode de montage d'une puce semi-conducteur selon la revendication 10, dans laquelle ledit moyen de transport (4) de la puce semi-conducteur est équipé d'au moins une partie transparente (4e) et accroche et maintient ladite puce semi-conducteur (C) par sa surface entière (4aa) de l'autre côté de ladite partie transparente (4e).

12. Méthode de montage d'une puce semi-conducteur selon une quelconque des revendications 7 à 11, dans laquelle :
- ledit moyen de transport (4) de la puce semi-conducteur possède une partie transparente (4e) qui laisse passer la lumière visible jusqu'à la puce semi-conducteur (C) maintenue, et dans laquelle
- ladite étape de positionnement laisse passer la lumière visible à travers la puce semi-conducteur (C) et à travers ladite partie transparente (4e) et la saisit à l'aide dudit moyen de saisie (6).
